# EUROPEAN PATENT APPLICATION

(11) **EP 4 600 671 A1**
(43) Date of publication of application: **13.08.2025**
(21) Application number: 24156713.0
(22) Date of filing: 09.02.2024
(51) Int. Cl.: G01R 31/28, H04B 17/00

(54) **SYSTEM AND METHOD FOR TESTING A DEVICE-UNDER-TEST**

(71) Applicant: Rohde & Schwarz GmbH & Co. KG, 81671 München (DE)
(72) Inventor: Scholl, Simon, 86150 Augsburg (DE)
(74) Representative: Rupp, Christian

(57) **Abstract**

The disclosure relates to a system (10) for testing a device-under-test, DUT (20). The system comprises: an output port (11) arranged for being connected to the DUT (20); a waveform generator (13) configured to generate an RF output signal and to forward said RF output signal to the DUT (20) via the output port (11); a communication interface (12) configured to receive a feedback signal from the DUT (20); and a processing unit (14) configured to dynamically generate waveform information based on the received feedback signal, wherein the processing unit (14) is configured to generate the waveform information from stored and/or from real time calculated waveform samples; wherein the waveform generator (13) is configured to adjust the RF output signal based on the waveform information.

## Description

### TECHNICAL FIELD

The present disclosure relates to a system, in particular an RF signal generator, and to a method for testing a device-under-test (DUT).

### BACKGROUND

RF signal generators can be used to provide precisely specified RF test signals to DUTs. For instance, the DUT is a communication device, such as a base station, and the RF test signals represent communication signals according to a communication standard. During such testing, the test signals can be adjusted manually by an operating of the signal generator based on a response of the DUT. However, this is approach is cumbersome and time consuming.

Furthermore, in the development of new mobile communication standards, machine learning (ML) models will be used for identifying optimized signal parameters (e.g., using ML models on predefined channel conditions to develop new modulation types for the standard that are better adapted to the channel). These ML models and, thus, the generated signals should be adapted in real time according to existing channel conditions. Thus, for training and verifying such ML models, a feedback mechanism is required that allows an adaption of "real" RF signal characteristics (not only of the fading channel) according to the adapted model.

### SUMMARY

Thus, it is an objective to provide an improved system and an improved method for testing a DUT which avoid the above-mentioned disadvantages.

The objective is achieved by the solution provided in the enclosed independent claims. Advantageous implementations of the present disclosure are further defined in the dependent claims.

According to a first aspect, the present disclosure relates to a system for testing a device-under-test (DUT). The system comprises: an output port arranged for being connected to the DUT; a waveform generator configured to generate an radio frequency (RF) output signal and to forward said RF output signal to the DUT via the output port; a communication interface configured to receive a feedback signal from the DUT; and a processing unit configured to dynamically generate waveform information based on the received feedback signal, wherein the processing unit is configured to generate the waveform information from stored and/or from real time calculated waveform samples; wherein the waveform generator is configured to adjust the RF output signal based on the waveform information.

This achieves the advantage that a feedback mechanism for a dynamic adaption of an RF test signal is provided. For instance, the system can be used for test scenarios which require switching between various predefined signals (signal-permutation) in real time.

The feedback mechanism provided by the system has the further advantage of not being specific to a certain application (i.e., it is generic). For instance, RF output signals according to various types of standards can be generated and/or adapted (e.g., by selecting from different types of stored waveform segments) and different types of DUTs can be connected. The system can be highly adaptable and can use various stored waveform data (e.g., in a ".wvs" or other data format), which can be provided by a user based on specific test scenarios.

The testing of the DUT can be a hardware-in-the-loop (HIL) testing. The DUT can be a communication device which is capable of providing a feedback signal, e.g. a base station.

The feedback signal from the DUT can be received while the RF output signal is forwarded to the DUT.

The stored waveform samples can be precalculated or preconfigured waveform samples which are stored in a memory of the system.

Each waveform sample can be subdivided in parts of different durations (i.e., temporal length). For instance, a part of a waveform sample suitable for generating RF output signals according to a 5G standard can have a length of 125 us, and a part of a waveform sample suitable for generating RF output signals according to an LTE standard can have a length of 500 µs.

The waveform samples can comprise IQ data. The waveform information can comprise an IQ data stream which is generated based on the IQ data.

The processing unit can comprise or be formed by a digital signal processor (DSP).

The processing unit dynamically generating the waveform information based on the feedback may refer to the processing unit generating (or updating) the waveform information directly in response to the feedback signal. For instance, the waveform generator outputs an RF output signal based on waveform information (e.g., an IQ data stream) from the processing unit, the interface receives a feedback to this RF output signal, and the processor directly adapts/changes the waveform information (e.g., adapts the IQ data stream) based on this feedback, causing the waveform generator to adapt the RF output signal accordingly.

The waveform generator can comprise a waveform player for "replaying" the waveform samples and generating the RF output signal from these samples.

In an embodiment, the processing unit comprises a feedback interpreter configured to generate and/or update a feedback configuration based on the feedback signal, wherein the feedback configuration comprises a number of consecutive segments, wherein each segment references or comprises a part of a respective stored or calculated waveform sample having a determined duration.

Thus, the feedback configuration can represent a sequence or string of waveform segments, each waveform segment having a certain duration. The RF output signal can be continuously generated or adapted based on said sequence. For instance, while an RF output signal is generated based on one waveform segment, the next segment in the feedback configuration can be generated / adjusted based on the feedback signal.

In an embodiment, the processing unit comprises a feedback configurator configured to map, for each segment, the feedback signal to the respective part of the stored or calculated waveform sample based on a mapping rule and to forward said mapping to the feedback interpreter; wherein the feedback interpreter is configured to generate the feedback configuration based on said mapping.

The processing unit or more specifically the feedback configurator can comprise a preselector which is configured to determine from the feedback message which waveform segments should be selected or calculated.

In an embodiment, the feedback configurator is configured to calculate at least one waveform sample based on the feedback message in real time.

In an embodiment, the processing unit comprises a sample provider configured to continuously receive the feedback configuration and to dynamically generate the waveform information based on the parts of the stored or calculated waveform samples referenced in or comprised by the consecutive segments in the feedback configuration.

For instance, the sample provider is an IQ sample provider (or IQ sample creator) which is configured to combine the IQ data of the waveform segments to an IQ data string which can be fed to the waveform generator for generating/adapting the RF output signal.

In an embodiment, the system comprises a memory configured to store the stored waveform samples.

The stored waveform samples can comprise waveform samples provided by a user or third party, and/or precalculated or preconfigured waveform samples.

In an embodiment, the memory is a shared memory in a communication network. This provides the advantage that waveform data from different users or other entities can be stored in a shared hardware.

In an embodiment, the system further comprises an access unit for accessing the memory and to forward the parts of the stored waveform samples from the memory to the sample provider. The access unit can forward the parts of the stored waveform samples according to the feedback configuration.

In an embodiment, the access unit is further configured to receive further waveform samples of different duration and/or with different characteristics and to store said further waveform samples in in the memory.

In an embodiment, the communication interface is a wireless or wire-bound interface.

For instance, the communicating interface can be a Bluetooth interface or a USB interface.

The feedback signals can be proprietary messages or DCI (5G standard) messages.

In an embodiment, the communication interface is a serial interface configured to receive the feedback signal with a serial data rate.

In an embodiment, the waveform generator comprises an IQ sample streamer and/or a digital-to-analog, DAC, converter.

The waveform samples and/or the waveform information can be digital data. The generated RF output signal can be an analog output signal.

The waveform generator (or player) can be configured to replay predefined waveforms or parts of predefined waveforms to generate a desired RF output signal. The IQ sample streamer can be configured to take IQ samples from a source (e.g. the sample provider) and forward them to the DAC converter. For instance, the IQ sample streamer thereby writes the IQ samples to a shared hardware with the DAC converter. The DAC converter can be a DAC IQ player.

In an embodiment, the waveform generator and the processing unit are integrated in a common device, or the waveform generator is a standalone device.

In an embodiment, the waveform generator is configured to receive the waveform information in the form of an IQ data stream, wherein the waveform generator is configured to dynamically adjust the RF output signal based on the IQ data stream.

In an embodiment, the system is an RF signal generator.

According to a second aspect, the present disclosure refers to a method for testing a device-under-test (DUT). The method comprising: generating an RF output signal and forwarding said RF output signal to a DUT; receiving a feedback signal from the DUT; dynamically generating waveform information based on the received feedback signal, wherein the waveform information is generated from stored and/or from real time calculated waveform samples; and adjusting the RF output signal based on the waveform information.

### BRIEF DESCRIPTION OF THE DRAWINGS

The above described aspects and implementations are explained in the following description of embodiments with respect to the enclosed drawings:
- Fig. 1: shows a schematic diagram of a system for testing a DUT according to an embodiment;
- Fig. 2: shows a generation of an RF output signal from stored waveform samples according to an embodiment;
- Fig. 3: shows a mapping rule according to an embodiment;
- Fig. 4: shows a schematic diagram of a system for testing a DUT according to an embodiment; and
- Fig. 5: shows a flow diagram of a method for testing a DUT according to an embodiment.

### DETAILED DESCRIPTION OF EMBODIMENT

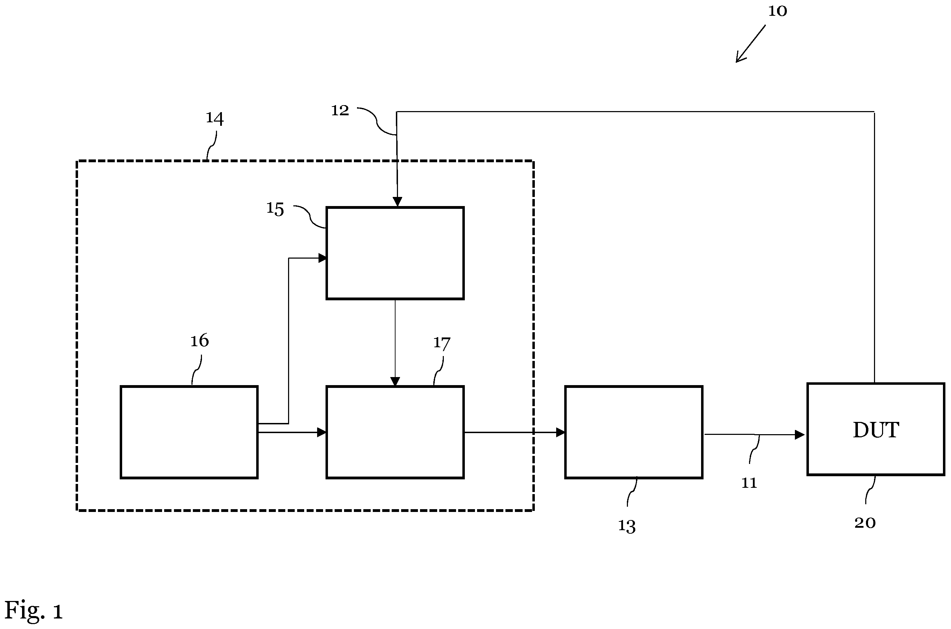

Fig. 1 shows a schematic diagram of a system 10 for testing a DUT 20 according to an embodiment.

The system 10 comprises an output port 11 arranged for being connected to the DUT 20; a waveform generator 13 configured to generate an RF output signal and to forward said RF output signal to the DUT 20 via the output port 11; and a communication interface 12 configured to receive a feedback signal from the DUT 20. The system 10 can further comprise a processing unit 14 configured to dynamically generate waveform information based on the received feedback signal, wherein the processing unit 14 is configured to generate the waveform information from stored and/or from real time calculated waveform samples; and wherein the waveform generator 13 is configured to adjust the RF output signal based on the waveform information.

The output port 11 can be an RF port.

The RF output signal can be configured according to a test scenario and further adapted based on the feedback signal. For instance, the RF output signal correspond to a signal according to a communication standard, e.g. 5G or LTE.

The communication interface 12 can be a wireless or wire-bound interface. For instance, the communicating interface 12 can be a Bluetooth interface or a USB interface.

The feedback signal from the DUT 20 can be received while the RF output signal is forwarded to the DUT 20. The feedback signal can comprise proprietary messages or DCI (5G standard) messages.

The stored or calculated waveform samples and/or the waveform information can be digital data. The waveform samples can comprise IQ data. The waveform information can comprise an IQ data stream which is generated based on the IQ data.

Each waveform sample can be subdivided in parts of different durations (i.e., temporal length). For instance, a part of a waveform sample suitable for generating RF output signals according to a 5G standard can have a length of 125 µs, and a part of a waveform sample suitable for generating RF output signals according to an LTE standard can have a length of 500 µs.

The generated RF output signal, which is forwarded to the DUT 20, can be an analog output signal.

The processing unit can comprise one or more microprocessors of the system 10.

The waveform generator 13 can be an IQ sample player. The waveform generator 13 can be configured to receive the waveform information in the form of an IQ data stream, and dynamically adjust the RF output signal based on the IQ data stream.

The processing unit 14 can comprise a feedback interpreter 15 which is configured to generate and/or update a feedback configuration based on the feedback signal. The feedback configuration can comprise a number of consecutive segments, wherein each segment references or comprises a part of a respective stored or calculated waveform sample having a determined duration.

For instance, the duration of the waveform sample parts in each segment can vary and can be adjusted by the feedback interpreter 15.

The feedback interpreter 15 can update the feedback configuration continuously based on the feedback signal, by adding new segments which refer to or comprise (parts of) waveform samples based on the currently feedback signal. The length of the waveform samples in each segment can determine an update rate of the feedback configuration.

The processing unit 14 can further comprises a feedback configurator 16 configured to map, for each segment, the feedback signal to the respective part of the stored or calculated waveform sample based on a mapping rule and to forward said mapping to the feedback interpreter 15. The feedback interpreter 15 can then generate the feedback configuration based on said mapping.

The processing unit 14 or more specifically the feedback configurator 16 can comprise a preselector (not shown in Fig. 1) which is configured to determine from the feedback message which waveform segments should be selected or calculated.

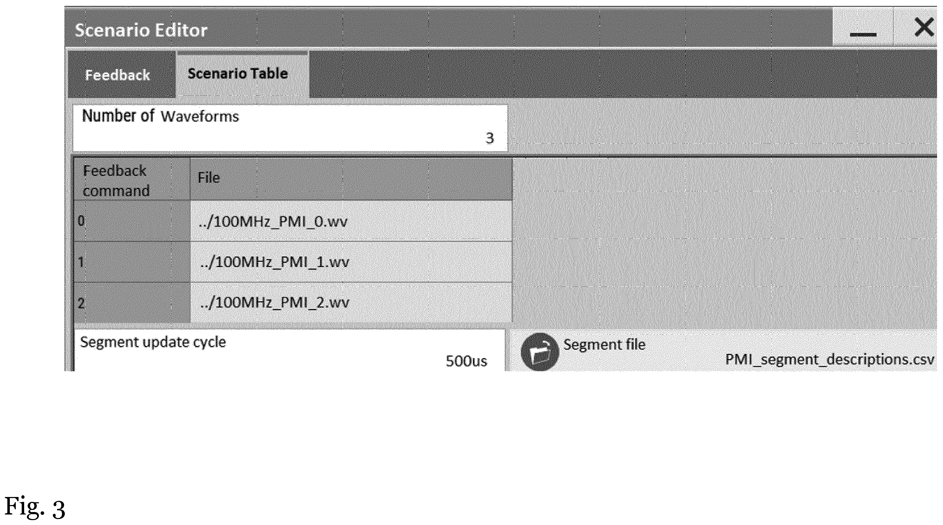

The feedback configuration can be generated in the form of a config table based on said mapping. In the config table commands received with the feedback signal are mapped to different waveform samples according to the mapping rule. For instance, the config table can refer to the waveform samples by their file name and storage location. The waveform samples can be stored as ".wv" files. Fig. 3 shows an example of a mapping rule.

For example, this config table is generated by the feedback configurator 16 and forwarded to the feedback interpreter 15 and/or directly to a sample provider 17.

The sample provider 17 can be a component of the processing unit 14 which receives the feedback configuration (e.g., in form of the config table). The sample provider 17 can receive the feedback configuration continuously while it is generated based on the currently received feedback signal.

The sample provider 17 can then dynamically generate the waveform information based on the parts of the stored or calculated waveform samples referenced in or comprised by the consecutive segments in the feedback configuration.

The sample provider 17 can be an IQ sample provider which generates the waveform information in form of an IQ data stream and which forwards said IQ data stream to the waveform generator 13.

The waveform generator 13 can comprise an IQ sample player configured to replay the IQ sample stream and to generate and/or adapt the RF output signal based on the IQ sample stream.

In particular, the system 10 and the implemented feedback mechanism can be independent of: the type of RF output signal to be generated (e.g., size of its segments, type of waveform samples), the application (generic solution based on ".wvs" samples, not application specific), the spec definitions (user can define a custom scenario by combining parts of waveform samples of various types and lengths.

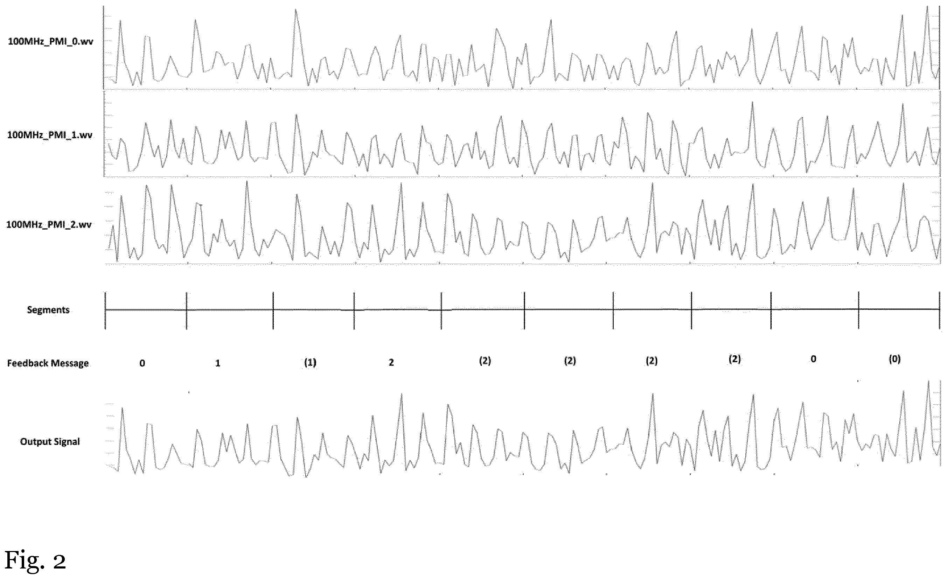

Fig. 2 shows a generation of an RF output signal from stored waveform samples according to an embodiment.

For instance, three waveform samples are provided in Fig. 2 (top three signals). In this example, each of the waveform samples is a 100 MHz signal provided in a ".wv" data format. These waveforms can be calculated or stored in a memory of the system 10.

The feedback signal (here referred to as feedback message) can comprise a number of commands in a certain order (e.g., 0, 1, (1), 2, etc., wherein the (1) can indicate that no other feedback signal respectively command has arrived and therefore to continue with segments of waveform 1). The processor unit 14, in particular the feedback interpreter 15 and/or feedback configurator 16, can interpret these commands and assign each command to a segment of a certain timespan, e.g., based on the mapping rule that maps the commands to the respective waveform samples.

An exemplary mapping rule is shown in Fig. 3. The length of the segments can be determined by the processor unit 14, in particular the feedback interpreter 15 and/or feedback configurator 16, based on the feedback signal itself or based on a user input. In the example shown in Fig. 3, the segment length is 500 µs.

By aligning the respective parts of the waveform samples to the segments a composite waveform sample is formed ("output signal" in Fig. 2). The composite waveform can correspond to the waveform information and can define the RF output signal to be generated.

This waveform information can be forwarded to the waveform generator 13, which generates the RF output signal based on the composite waveform signal.

In summary, the system can switch its RF output between different waveforms (e.g., provided as .wv files) based on the feedback signal. Thereby, the system 10 can freely choose which waveforms to combine, how many waveforms to combine and how to segment the waveforms based on the feedback signal.

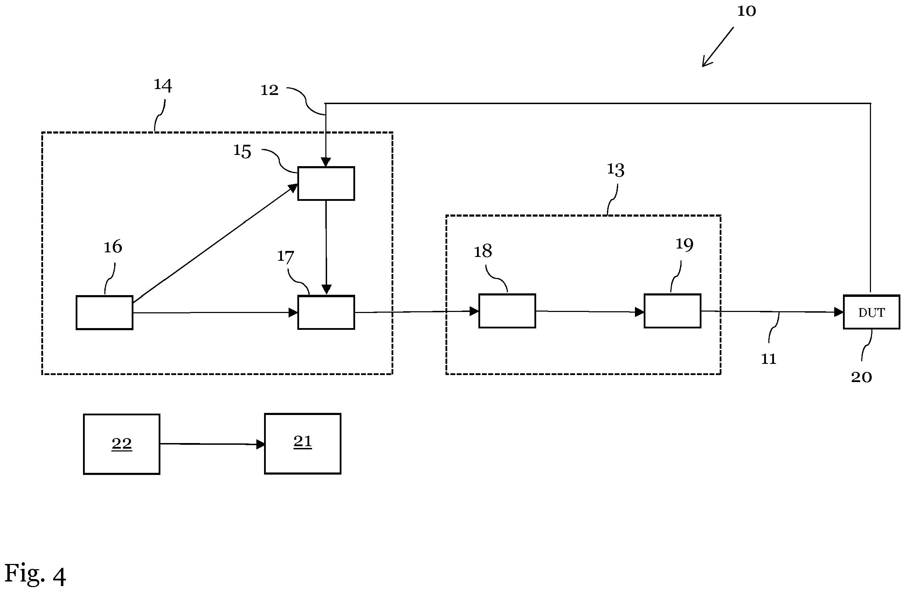

Fig. 4 shows the system 10 for testing the DUT 20 according to a further embodiment. The exemplary system 10 as shown in Fig. 4 can comprise all components and functions of the system 10 as shown in Fig. 1.

The DUT 20 can be a communication device which is capable of providing a feedback signal, e.g. a base station. The DUT 20 can comprise an RF input port which is connected to the RF output port 11 of the system 10 to receive the RF output signal. The DUT 20 can further comprise a communication interface which is communicatively connected to the system interface 12 for forwarding the feedback signal.

The communication interface 12 can comprise a serial interface configured to receive the feedback signal with a serial data rate (e.g., 1.92 MBits/s).

In addition or alternatively, the communication interface 12 can also comprise an Ethernet interface or an RF interface. In case the interface is an Ethernet interface, the feedback signal can be a User Datagram Protocol (UDP) message. In case the interface is an RF interface, the feedback signal can be a Downlink Control Information (DCI) message.

The feedback interpreter 15 can convert incoming feedback signals into the feedback configuration which is forwarded to the sample provider 17.

The feedback configurator 16 can map feedback signals to precalculated sample files (e.g..wv files). In addition or alternatively, the feedback configurator 16 can calculate the waveguide samples based on the feedback signal. This calculation of the waveguide sample(s) can be carried out by a calculation unit.

The feedback configurator 16 can be a "user interface" for mapping the feedback signal to the waveguide samples (e.g., NR5G files). The feedback configurator 16 can forward a table with this mapping to the feedback interpreter 15 and/or to the sample provider 17. In case of stored waveguide samples, these samples could be forwarded together with the "mapping table" to the sample provider 17.

The sample provider 17 can be an IQ sample creator 17 which can generate waveguide information in the form of an IQ data stream based on the feedback configuration. For instance, the sample provider 17 can trigger real time calculations of IQ samples based on the feedback configuration (e.g., plugin specific recall files) and forward said IQ samples to an IQ sample streamer 18. The sample provider 17 can also select, based on the feedback configuration, stored IQ samples (e.g., the .wv files) and forward these to the IQ sample streamer 18.

The IQ sample streamer 18 can be a component of the processing unit 14 or of the waveform generator 13 (as shown in Fig. 4) . The waveform generator 13 can further comprise a digital-to-analog converter (DAC), e.g. in the form of a DAC IQ player 19.

The IQ sample streamer 18 can be configured to receive the IQ samples from the sample provider 17 in digital form and either write these samples in a shared memory of with the DAC IQ player 19 or forward the samples directly to the DAC IQ player 19, e.g. via a network interface.

The DAC IQ player 19 can convert the digital IQ data stream to the analog RF output signal.

The total delay of the sample provider 17 and the IQ sample streamer 18 can be < 1NR-slot (< 125 ps= for 5G applications). The selection of stored and precalculated samples and/or the use of the shared memory can reduce this delay.

The system 10 can further comprise a further memory 21 which is configured to store the waveform samples. The stored waveform samples can comprise waveform samples provided by a user or third party and/or precalculated/preconfigured waveform samples.

The memory 21 can be a further shared memory in a communication network. Thus, waveform data from different users or other entities can be stored in a shared hardware.

The memory 21 can also comprise a buffer for storing the precalculated waveforms.

The system can further comprise an access unit 22 for accessing the memory. The access unit 22 can be configured to select different stored waveform samples, e.g., to forward the samples to the sample provider 17.

The access unit 22 can further configured to store new waveform or waveform parts with different characteristics, in particular timespans, in the memory 21. For instance, this can be waveforms provided by a user for a specific application scenario.

The waveform generator 13 and the processing unit 14 can integrated in a common device. This device can be an RF signal generator.

Alternatively, the waveform generator 13 can be a standalone device which is communicatively connected to the processing unit 14 (e.g., a PC). Further, the various components of the processing unit 13 and the waveform generator 13 could also be distributed over various device (streaming approach).

In the following, possible modes of operation and use cases of the system 10 are discussed:

In general, standard and scenario specific IQ segments/samples can be recalculated and stored in the memory 21 of the system 10 (e.g., in an arbitrary waveform memory, ARB). This memory 21 can be shared between a host and a DSP of the processing unit 14. Further, a table which maps addresses of these IQ segments/samples to the feedback signal can be provided to the DSP. The feedback signal can be interpreted by the DSP according to this mapping, and the result can be written in a specific address region of an arbitrary waveform (ARB) player of the system 10, e.g. of the signal generator 13. This approach allows to configure the IQ samples (e.g., via .wv files), the segmentation (e.g., based on a list) and the mapping of the feedback message, independently of a specific use case or communication scenario.

Example 1: The waveform samples are precalculated and the feedback signal is received on an external PC. The PC can comprise the feedback interpreter 15, the feedback configurator 16, the IQ sample provider 17, and the IQ streamer 18 and can forward the data via a high-speed Ethernet connection to the IQ player 19, e.g. a VSG (player) . This has the advantage that due to the streaming, the system 10 is not limited to the shared ARB memory (2.4 GHz samples). Furthermore, the IQ player 19 can be less complex. It is further possible that the waveform data is calculated in real time, which no longer requires the data to the precalculated. For instance, in this case, the system 10 is only provided a configuration which it uses to real time calculate the waveform data.

Example 2: The interface 12 and/or feedback interpreter 15 in the DSP could be realized as an RF interface, e.g. RF-DCI with feedback interpreter (e.g., a Universal Software Radio Peripheral, USRP). This has the advantage that the DUT 20 does not need a dedicated interface (e.g., serial) to send messages to the system interface 12. Instead, it could issue "normal" DCI feedback messages via an existing RF output port.

The system 10 can be used in the context of 5G testing, e.g. for testing base stations. For instance, 5G test specifications contain defined feedback scenarios that must be fulfilled by the base station to be 3GPP compliant. The generic feedback capability of the system 10 can be used for further tests of such a base station in earlier stages of the base station development, prior to protocol testing (e.g., for power adjustment, modulation adjustment, or precoding adjustment).

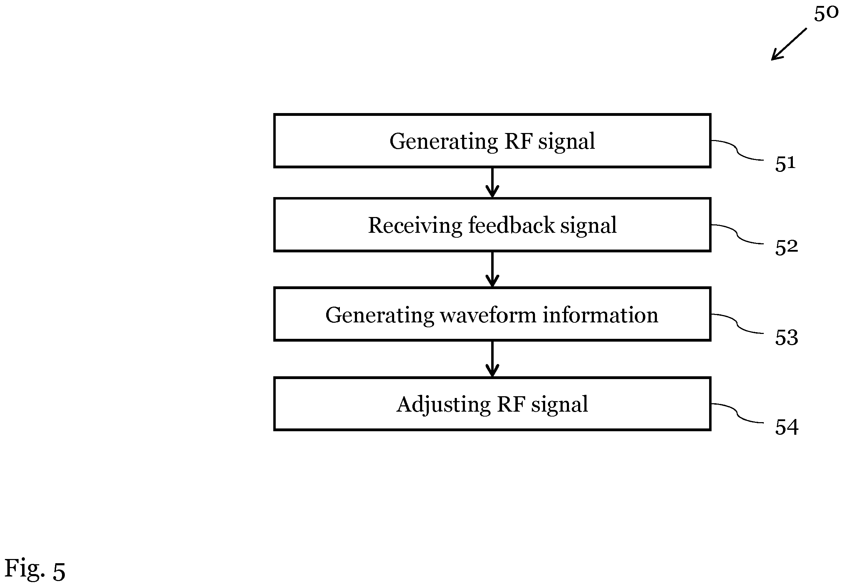

Fig. 5 shows a flow diagram of a method 50 for testing the DUT 20 according to an embodiment.

The method 50 comprises the steps of: generating 51 the RF output signal and forwarding said RF output signal to the DUT 20; receiving 52 the feedback signal from the DUT 20; dynamically generating 53 the waveform information based on the received feedback signal, wherein the waveform information is generated from the stored and/or from real time calculated waveform samples; and adjusting 54 the RF output signal based on the waveform information.

The method 50 can be carried out by the system 10, as e.g. shown in Figs. 1 and 4.

## Claims

1. A system (10) for testing a device-under-test, DUT (20), comprising:
an output port (11) arranged for being connected to the DUT (20);
a waveform generator (13) configured to generate an RF output signal and to forward said RF output signal to the DUT (20) via the output port (11);
a communication interface (12) configured to receive a feedback signal from the DUT (20); and
a processing unit (14) configured to dynamically generate waveform information based on the received feedback signal, wherein the processing unit (14) is configured to generate the waveform information from stored and/or from real time calculated waveform samples;
wherein the waveform generator (13) is configured to adjust the RF output signal based on the waveform information.

2. The system (10) of claim 1,
wherein the processing unit (14) comprises a feedback interpreter (15) configured to generate and/or update a feedback configuration based on the feedback signal, wherein the feedback configuration comprises a number of consecutive segments, wherein each segment references or comprises a part of a respective stored or calculated waveform sample having a determined duration.

3. The system (10) of claim 2,
wherein the processing unit (14) comprises a feedback configurator (16) configured to map, for each segment, the feedback signal to the respective part of the stored or calculated waveform sample based on a mapping rule and to forward said mapping to the feedback interpreter (15);
wherein the feedback interpreter (15) is configured to generate the feedback configuration based on said mapping.

4. The system (10) of claim 3,
wherein the feedback configurator (16) is configured to calculate at least one waveform sample based on the feedback message in real time.

5. The system (10) of any one of claims 2 to 4
wherein the processing unit (14) further comprises a sample provider (17) configured to continuously receive the feedback configuration and to dynamically generate the waveform information based on the parts of the stored or calculated waveform samples referenced in or comprised by the consecutive segments in the feedback configuration.

6. The system (10) of any one of the preceding claims, comprising:
a memory (21) configured to store the stored waveform samples.

7. The system (10) of claim 6,
wherein the memory (21) is a shared memory in a communication network.

8. The system (10) of claim 5 and of claim 6 or 7,
wherein the system further comprises an access unit (22) for accessing the memory (21) and to forward the parts of the stored waveform samples from the memory to the sample provider (17) .

9. The system (10) of claim 8
wherein the access unit (22) is further configured to receive further waveform samples of different duration and/or with different characteristics and to store said further waveform samples in in the memory (21).

10. The system (10) of any one of the preceding claims,
wherein the communication interface (12) is a wireless or wire-bound interface.

11. The system (10) of any one of the preceding claims,
wherein the communication interface (12) is a serial interface configured to receive the feedback signal with a serial data rate.

12. The system (10) of any one of the preceding claims,
wherein the waveform generator (13) comprises an IQ sample streamer (18) and/or a digital-to-analog, DAC, converter.

13. The system (10) of any one of the preceding claims,
wherein the waveform generator (13) and the processing unit (14) are integrated in a common device, or wherein the waveform generator (13) is a standalone device.

14. The system (10) of any one of the preceding claims,
wherein the waveform generator (13) is configured to receive the waveform information in the form of an IQ data stream, wherein the waveform generator is configured to dynamically adjust the RF output signal based on the IQ data stream.

15. The system (10) of any one of the preceding claims,
wherein the system (10) is an RF signal generator.

16. A method (50) for testing a device-under-test, DUT (20), comprising:
generating (51) an RF output signal and forwarding said RF output signal to a DUT (20);
receiving (52) a feedback signal from the DUT (20);
dynamically generating (53) waveform information based on the received feedback signal, wherein the waveform information is generated from stored and/or from real time calculated waveform samples; and
adjusting (54) the RF output signal based on the waveform information.
